(19) **Europäisches Patentamt / European Patent Office / Office européen des brevets**

(11) **EP 2 059 927 B1**

(12) **EUROPEAN PATENT SPECIFICATION**

(45) Date of publication and mention of the grant of the patent:
**24.02.2010 Bulletin 2010/08**

(21) Application number: **07826133.6**

(22) Date of filing: **27.08.2007**

(51) Int Cl.:
*G11B 7/125* (2006.01)

(86) International application number:
**PCT/IB2007/053405**

(87) International publication number:
**WO 2008/026143 (06.03.2008 Gazette 2008/10)**

(54) **AN OPTICAL DRIVE WITH IMPROVED LASER POWER CONTROL (LPC)**

OPTISCHES LAUFWERK MIT VERBESSERTER LASER POWER CONTROL (LPC)

LECTEUR OPTIQUE AVEC COMMANDE DE PUISSANCE LASER AMÉLIORÉE (LPC)

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **30.08.2006 EP 06119764**

(43) Date of publication of application:
**20.05.2009 Bulletin 2009/21**

(73) Proprietor: **Koninklijke Philips Electronics N.V.**
**5621 BA Eindhoven (NL)**

(72) Inventors:
• **VAN RENS, Jeannet**
**5656 AE Eindhoven (NL)**
• **LOOIJKENS, Mario**
**5656 AE Eindhoven (NL)**
• **MCCORMACK, James, J., A.**
**5656 AE Eindhoven (NL)**

(74) Representative: **Uittenbogaard, Frank**
**Philips**
**Intellectual Property & Standards**
**P.O. Box 220**
**5600 AE Eindhoven (NL)**

(56) References cited:
**WO-A-2004/105004      US-A1- 2002 114 242**
**US-A1- 2004 120 369      US-B1- 6 408 013**

**Description**

FIELD OF THE INVENTION

The present invention relates to an optical drive or an optical recording apparatus for recording on an associated optical carrier, the optical drive comprising means for re-calibrating a power level of a radiation beam, e.g. a laser beam, used for recording. The invention also relates to corresponding controlling means and a corresponding method.

BACKGROUND OF THE INVENTION

During optical recording of an optical disk or carrier, for rewriteable media, a laser beam is applied to selectively crystallize or make amorphous a phase-changing material in dependency of the data to be writing on the optical disk or carrier. Equally, for write-once media, a laser beam is applied to selectively to alter/burn away/deform (dye) material or not, in dependency of the data to be writing on the optical disk or carrier. The laser is driven using a pulse form that contains higher frequency component than the channel rate itself. This has the form of a multi-level pulse with the purpose of writing a "mark" or a "space" at a given length in response to the encoded data. The conversion of encoded data, also known as no-retum-to-zero data (NRZ), to a pulse train with higher time resolution and multiple power levels is performed by a so-called write strategy. It is therefore imperative that the power of the applied laser beam is controlled with a relatively high degree of precision in order to implement the specific write strategy for a given set of data on a certain optical disc.

Typically, laser power control (LPC) is performed by sampling a laser beam feedback signal from a photodiode named the forward sense (FS). The photodiode is either positioned within a portion of the laser beam, or alternatively a portion of the laser beam is directed to the photodiode via beam splitting means, e.g. a so-called leaky prism beam splitter or a leaky mirror. Alternatively, laser power control (LPC) could be performed by test writing in dedicated power calibration areas (PCA) on the disc in the same regions where "optimum power control" (OPC) is also performed, but this is an open-loop/feed-forward method and it is not as stable and efficient as forward sense (FS) control. Forward sense control may also be referred to as forward monitor (FM) control.

In the forward sense (FS) method, a feedback control loop is established with the respect to the laser power. The feedback control in principle thereby enables a continuous monitoring of the laser power, but due to the relatively high level of laser power and/or the fast alternation of the laser power due the write strategy applied, it is not possible to continuously monitor the actual laser power, and accordingly various models predicting the actual behavior of the laser under e.g. higher power can be applied to remedy this shortcoming of the forward sense (FS) method. For example a linear relationship between the laser current and the resulting laser power various solution for laser power control (LPC) have been presented see e.g. US Patent 6,577,655 or US Patent application 2004/00552185.

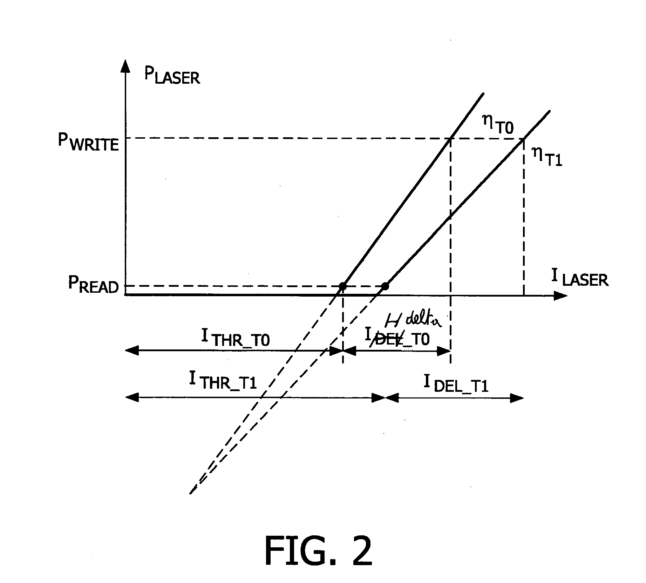

WO 2004/105004 also discloses a solution for laser power control (LPC) where a linear relationship between the radiation power of the laser and the laser current is utilized, cf. Figure 2. Due to drift of the linear coefficients, i.e. the current threshold and the delta current, describing the relationship between the power and current - caused in turn by aging and/or changing temperature - WO 2004/ 105004 proposes to re-calibrate the aforementioned linear coefficients during the life time of the optical drive. Specifically, for at least two threshold currents the linear coefficients - or more generally coefficients of an interrelating function F - are updated. A disadvantage of this solution is therefore that at least two different thresholds have to be found for the laser which necessitates a considerable use of time due to cooling or heating of the laser and therefore reading or writing can not take place during the re-calibration. Furthermore, this re-calibration requires the use of a relatively precise power meter in order to obtain a satisfactory re- calibration that is valid outside the range of power regime corresponding to the at least two current thresholds applied in the re-calibration.

US-B1-6 408 013 discloses an optical drive for recording information on an associated optical carrier, the optical drive comprising a radiation source arranged to be powered by a current provided by a current source, control means adapted to control the current source, the control means having stored calibrated values for a threshold current at which the radiation source radiates at a first predetermined power level, and a power target value determining a change current for which the threshold current needs to be increased in order to enable the radiation source to radiate at a second predetermined power level, and power controlling means capable of obtaining a power difference between a measured power level of the emitted radiation and a target power level of the emitted radiation, wherein the control means is adapted for re-calibrating a target value, using the corresponding threshold current, to a re- calibrated target value, and applying the re-calibrated target value for controlling the current source.

The problem to be solved by the present invention may therefore also be regarded as how to avoid a time-consuming laser characteristic detection wherein at least two different drive currents have to be applied for the laser, which necessitates a considerable use of time and thus whereby reading or writing can not take place during the re-calibration.

Hence, an improved optical drive would be advantageous, and in particular a more efficient and/or reliable optical would be advantageous.

SUMMARY OF INVENTION

Accordingly, the invention preferably seeks to mitigate, alleviate or eliminate one or more of the above mentioned disadvantages singly or in any combination. In particular, it may be seen as an object of the present invention to provide an optical drive that solves the above mentioned problems of the prior art with laser power control (LPC).

This object and several other objects are obtained in a first aspect of the invention by providing an optical drive for recording information on an associated optical carrier, the optical drive comprising:

- a radiation source arranged to be powered by a current provided by a current source,
- control means adapted to control the current source, the control means having stored calibrated values for:

    - a threshold current ($I\_THR\_0$) at which the radiation source radiates at a first predetermined power level ($P\_1$), and
    - a change current ($I\_delta\_0$) for which the threshold current needs to be increased in order to enable the radiation source to radiate at a second predetermined power level ($P\_2$), and

- power controlling means capable of obtaining a power difference ($delta\_P$) between a measured power level of the emitted radiation and a target power level of the emitted radiation,

wherein the control means is adapted for:

    1) re-calibrating the change current ($I\_delta\_0$), using the corresponding threshold current ($I\_THR\_0$), to a re-calibrated change current ($I\_delta\_1$) by application of the power difference ($delta\_P$), and
    2) applying the re-calibrated change current ($I\_delta\_1$) together with the calibrated threshold current ($I\_THR\_0$) for controlling the current source.

The invention is particularly, but not exclusively, advantageous for obtaining a simple and fast solution capable of compensating, in an efficient manner, drift in the characteristic response of the radiation source of the optical drive because the re-calibration of the present invention can be performed by refining or re-adapting the change current during operation of the optical drive. It is a distinct advantage of the present invention that the re-calibration of the change current can be performed with no or very little time consumption as compared to the prior art, in particular WO 2004/105004, as the re-calibration can be performed during e.g. a writing process of the optical drive. Additionally, the delicate fine-tuning of the change current that is possible with the present invention is particularly suited for multiple power level write strategies with high requirements on the precision and repeatability of the applied power levels. Such write strategies are more and more commonly applied in the field of optical drives.

In one embodiment, the control means may be further adapted for 3) applying the re-calibrated change current ($I\_delta\_1$) and the calibrated threshold current ($I\_THR\_0$) to implement a write strategy comprising multiple power levels. Thus, the control means can facilitate the implementation of a write strategy with multi level pulse trains now applied in many optical drives. This is different from simple write strategies applying a "block writing" strategy i.e. without alternating power levels. In particular, the write strategy of the present invention may also be capable of erasing an optically readable effect on the associated carrier i.e. performing deletion of a so-called "mark".

Beneficially, the optical drive may be adapted so that the step 1) of re-calibrating or fine-tuning is performed in parallel with a writing process being performed by the optical drive. This can significantly reduce the time spent on re-calibration because it can be performed while the optical drives writes information.

The step 1) of re-calibrating may be performed during a predetermined re-calibration period (RCP) wherein a closed-loop power control loop for the radiation source is temporally opened so as to facilitate that the re-calibration is not disturbed by the closed-loop. Advantageously, the re-calibration period (RCP) may be further divided into a first sub-period (RCP1), wherein any transients from the power control loop are allowed to substantially die out, and a second sub-period (RCP2), wherein the change current ($I\_delta\_0$) is re-calibrated.

Advantageously, the temperature of the radiation source may be substantially constant during the second sub-period (RCP2). This may justify that the threshold current ($I\_THR\_0$) is not re-calibrated as little changes may be expected of the threshold current during the second sub-period (RCP2). This will be further explained below.

In one embodiment, the calibrated threshold current ($I\_THR\_0$) and/or the calibrated change current ($I\_delta\_0$) may be stored in the control means during manufacturing of the optical drive, i.e. during assembly or production of the optical drive, a calibration can be performed using for example highly precise power meters for measuring the emitted radiation. However, due to aging this factory calibration may not be completely correct at a late point in time during the lifetime of the optical.

In another embodiment, the calibrated threshold current (I_THR_0) and/or the calibrated change current (I_delta_0) may be stored in the control means during a previous in-use calibration, i.e. a calibration performed after the optical drive has been manufactured and entered into a user environment. Such a calibration can be performed as an integral part of the normal use initiated either at regular intervals and/or by certain events/incidents during the normal use of the optical drive. In particular, the previous in-use calibration may comprise the sub-step of determining the radiation power and the corresponding change current for at least two different threshold currents. This is further explained in WO 2004/105004.

In a second aspect, the invention relates to control means adapted for controlling an optical drive capable of recording on an optical carrier, the control means being adapted to control a current source for powering a radiation source, the control means having stored calibrated values for:

- a threshold current (I_THR_0) at which the radiation source radiates at a first predetermined power level (P_1), and
- a change current (I_delta_0) for which the threshold current needs to be increased in order to enable the radiation source to radiate at a second predetermined power level (P_2), and

wherein the control means is adapted for:

1) re-calibrating the change current (I_delta_0), using the corresponding threshold current (I_THR_0), to a re-calibrated change current (I_delta_1) by application of a power difference (delta_P) between a measured power level of the emitted radiation and a target power level of the emitted radiation, and
2) applying the re-calibrated change current (I_delta_1) together with the calibrated threshold current (I_THR_0) for controlling the current source.

In a third aspect, the present invention relates to a method for operating an optical drive for recording information on an optical carrier (1), the method comprising the steps of:

- providing a current from a current source a to radiation source (4),
- providing control means (50, 22) adapted to control the current source, the control means having stored calibrated values for:

  - a threshold current (I_THR_0) at which the radiation source (4) radiates at a first predetermined power level (P_1), and
  - a change current (I_delta_0) for which the threshold current needs to be increased in order to enable the radiation source (4) to radiate at a second predetermined power level (P_2),

- obtaining a power difference (delta_P) between a measured power level of the emitted radiation and a target power level of the emitted radiation,
- re-calibrating the change current (I_delta_0), using the corresponding threshold current (I_THR_0), to a re-calibrated change current (I_delta_1) by application of the power difference (delta_P), and
- applying the re-calibrated change current (I_delta_1) together with the calibrated threshold current (1_THR_0) for controlling the current source.

In a fourth aspect, the invention relates to a computer program product being adapted to enable a computer system comprising at least one computer having data storage means associated therewith to control an optical drive according to the third aspect of the invention.

This aspect of the invention is particularly, but not exclusively, advantageous in that the present invention may be implemented by a computer program product enabling a computer system to perform the operations of the second aspect of the invention. Thus, it is contemplated that some known optical drive may be changed to operate according to the present invention by installing a computer program product on a computer system controlling the said optical recording apparatus. Such a computer program product may be provided on any kind of computer readable medium, e.g. magnetically or optically based medium, or through a computer based network, e.g. the Internet.

The first, second, third and fourth aspect of the present invention may each be combined with any of the other aspects. These and other aspects of the invention will be apparent from and elucidated with reference to the embodiments described hereinafter.

BRIEF DESCRIPTION OF THE DRAWINGS

The present invention will now be explained, by way of example only, with reference to the accompanying Figures, where

Figure 1 is a schematic diagram of an embodiment of an optical recording apparatus according to the invention,
Figure 2 is a graph of the current-power relationship for an irradiation source at two temperatures,
Figure 3 is a graph schematically showing the re-calibration performed according to the present invention,
Figure 4 is a graph schematically showing the timing of the present invention in an embodiment of the invention,
Figure 5 is graph showing the temperature development of a threshold current and a change current for a laser,
Figure 6 is a graph similar to the graph of Figure 3 at three different temperatures, and
Figure 7 is a flow chart of a method according to the invention.

DETAILED DESCRIPTION OF EMBODIMENTS

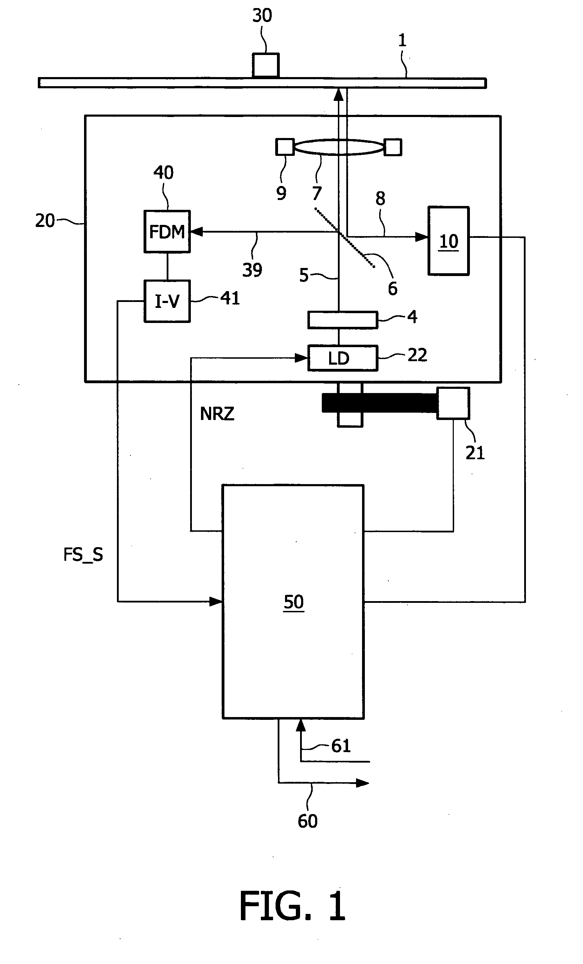

Figure 1 shows an optical recording apparatus or an optical drive and an optical carrier 1 according to the invention. The carrier 1 is fixed and rotated by holding means 30.
The carrier 1 comprises a material suitable for recording information by means of a radiation beam 5. The recording material may, for example, be of the magneto-optical type, the phase-change type, the dye type, metal alloys like Cu/Si or any other suitable material. Information may be recorded in the form of optically detectable regions, also called "marks" for rewriteable media, on the optical carrier 1.
The apparatus comprises an optical head 20, sometimes called an optical pickup (OPU), the optical head 20 being displaceable by actuation means 21, e.g. an electric stepping motor. The optical head 20 comprises a photo detection system 10, a laser driver device 30, a radiation source 4, a beam splitter 6, an objective lens 7, and lens displacement means 9 capable of displacing the lens 7 both in a radial direction of the carrier 1 and in the focus direction. The optical head 20 also comprises forwarding photo sensing means (FS), said sensing means comprising a photo detector 40, also known as the forward detecting monitor (FDM), and an amplifier 41, e.g. a current to voltage converter (I-V), with a scaleable electrical output signal FS_S that is transmitted to the processor 50 for further processing and analysis.
The function of the forwarding photo sensing means (FS) is to control the power level of the emitted radiation 5 from the irradiation source 4. A beam fraction 39 of the radiation beam 5 is directed from the beam splitter 6 towards the photo detector 40 so as to obtain a measure of the power of the radiation beam 5. Knowing the characteristics of the beam splitter 6 this is a standard procedure. Alternatively, the photo detector 40 may be positioned within the beam 5 so as to obtain a more direct measure of the power of the radiation beam 4.
The function of the photo detection system 10 is to convert radiation 8 reflected from the carrier 1 into electrical signals. Thus, the photo detection system 10 comprises several photo detectors, e.g. photodiodes, charged-coupled devices (CCD), etc., capable of generating one or more electric output signals. The photo detectors are arranged spatially to one another and with a sufficient time resolution so as to enable detection of error signals, i.e. focus error FE and radial tracking error RE. The focus error FE and radial tracking error RE signals are transmitted to the processor 50 where commonly known servomechanism operated by usage of PID control means (proportional-integrate-differentiate) is applied for controlling the radial position and focus position of the radiation beam 5 on the carrier 1.
The radiation source 4 for emitting a radiation beam or a light beam 5 can for example be a semiconductor laser with a variable power, possibly also with variable wavelength of radiation. Alternatively, the radiation source 4 may comprise more than one laser. In the context of the present invention the term "light" is considered to comprise any kind of electromagnetic radiation suitable for optical recording and/or reproduction, such as visible light, ultraviolet light (UV), infrared light (IR), etc.
The radiation source 4 is controlled by the laser driver device (LD) 22. The laser driver (LD) 22 comprises electronic circuitry means in particular a current source (not shown in Figure 1) for providing a control current to the radiation source 4 in response to a clock signal and a data signal NRZ transmitted from the processor 50. The processor 50 receives feedback, i.e. the FS_S signal, from the forward sensing means (FS) so as to assess the actual value of the power in the irradiation beam 5. If a deviation exits between the desired target level of power and the actual value of the power in beam 5, the processor 50 may generate appropriate control signals to the laser driver 22 and the radiation source 4 to correct the actual power level. Thus, a feedback control loop is established to control the power of the irradiation beam 4. The deviation between the desired target level of power and the actual value of the power in beam 5 is usually defined as a power error delta_P, and the function of the laser power control loop is to minimize, and if possible eliminate, the power error delta_P. In an embodiment, the amplifier 41 may be integrated into the laser drive 22. Alternatively, the amplifier 41 may be positioned outside the optical head 20, possibly within or near the processor 50.
The processor 50 receives and analyses signals from the photo detection means 10. The processor 50 can also output control signals to the actuation means 21, the radiation source 4, the lens displacement means 9, and the rotating means 30, as schematically illustrated in Figure 1. Similarly, the processor 50 can receive data to be written, indicated at 61, and the processor 50 may output data from the reading process as indicated at 60. While the processor 50 has been depicted as a single unit in Figure 1, it is to be understood that equivalently the processor 50 may be a plurality of interconnecting processing units positioned in the optical drive, possibly some of the units may be positioned in the optical head 20.

Figure 2 is a graph showing - in a schematic manner - the current-power relationship for an irradiation source at two temperatures; T0 and T1. On the vertical scale, the power of the irradiation source 4, i.e. the laser, is given; $P_{LASER}$. On the horizontal scale, the current provided by a current source in the laser driver (LD) 22 is given; $I_{LASER}$.

It appears that a linear equation can be used to describe the relation between threshold current ($I_{THR}$) and efficiency (slope $=\eta$ ) of the laser as further explained in US patent 6,577,655, which is hereby incorporated by reference in its entirety.

For completeness, the equation relating the threshold current $I\_THR$ to the slope $\eta$ is given by:

$$\frac{\eta_0}{\eta_T} = (1 - a) + a \times \frac{I_{THR\_T}}{I_{THR\_0}} \quad \Rightarrow \quad \frac{-\Delta\eta_T}{\eta_T} = a \times \frac{\Delta I_{THR\_T}}{I_{THR\_0}} \quad (1)$$

with:

$\eta_0$ = efficiency of the laser at a reference temperature
$\eta_T$ = efficiency of the laser at the current temperature
$I_{THR\_T}$ = threshold current of the laser at temperature T1
$I_{THR\_0}$ = threshold current of the laser at a reference temperature T0
a = dimensionless number that is characteristic for a certain type of laser.
T0, T1 = temperature that causes the laser to have a threshold current ITHR_0 respectively ITHR_T1. Note that the absolute value of the temperature is not important and might change with time and conditions.

Defining $I_{DEL} = \frac{P_{WRITE} - P_{READ}}{\eta}$ , the equation (1) can also be described in terms of $I_{DEL}$ according to:

$$\frac{\Delta I_{DEL\_T}}{I_{DEL\_0}} = a \times \frac{\Delta I_{THR\_T}}{I_{THR\_0}} \quad (2)$$

The formula (2) indicates that a relative change in threshold current (%$\Delta$-thr) will be accompanied together with a change in efficiency ($\eta$) such that the change in required delta current is: % $\Delta$ -del = a * % $\Delta$ -thr.

In fact, this relies on the assumption that a point can be located on a current-to-power graph that gives a virtual intersection point for all (extended) current-to-power slopes of the laser as indicated by the dashed curves in the lower half of the graph in Figure 2.

The intersection point (I_int, P_int) is on position:

$$I\_int = (1 - \frac{1}{a}) * I_{THR\_0}$$

$$P\_int = -\frac{1}{a} * I_{THR\_0} * \eta_0$$

The factor "a" is a characteristic of the (type of) laser. It is possible to find the position of a first curve by adjusting the value of $I_{THR\_0}$ and $\eta_0$ ($\equiv 1/I_{DEL\_0}$). With this curve and with the assumed or measured value of "a" the virtual intersection point can be calculated and we can predict the shift of the curves at other temperatures.

However, it is the experience of the present inventors that the aforementioned factor "a", and equivalently corresponding values of threshold current I_THR and change current I_delta, can change during aging of the radiation source 4. Accordingly, there is an advantage in being able to re-calibrate these values in the optical drive. There is also a significant performance improvement through the higher accuracy achieved for the factor "a" when re-calibrating.

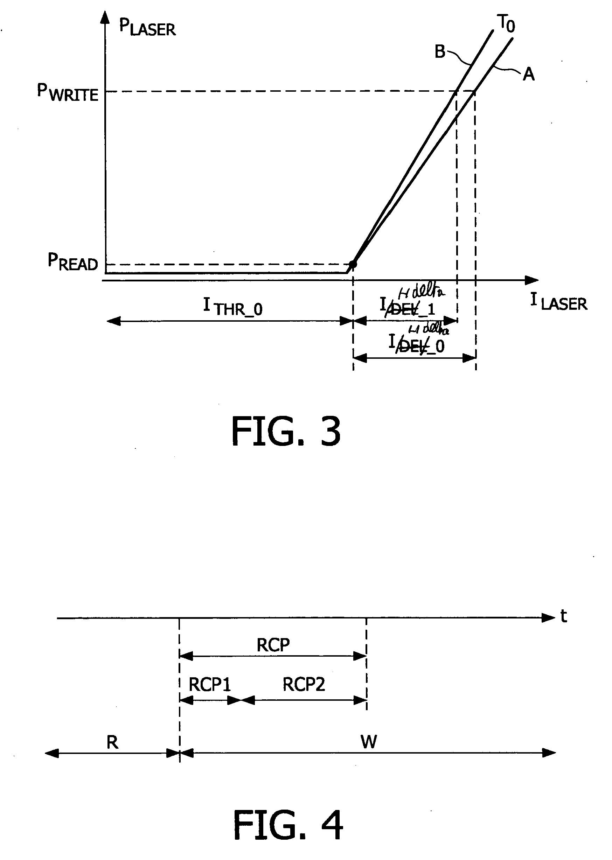

Figure 3 is a graph schematically showing the re-calibration performed according to the present invention. In order to facilitate the implementation of the invention, the control means, i.e. processing means 50 and control means within the laser driver (LD) 22, are adapted to control the current source within the laser driver (LD) 22. The control means have stored one or more calibrated values for a threshold current I_THR_0 at which the radiation source 4 radiates at a first predetermined power level P_READ.

Additionally, a change current I_delta_0 for which the threshold current I_THR needs to be increased in order to enable the radiation source to radiate at a second predetermined power level P_WRITE is stored in the control means. These values of threshold current I_THR_0 and the change current I_delta_0 correspond to the curve A in Figure 3 at some temperature T0.

Further, power controlling means 40 and 41 are capable of obtaining a power difference delta_P between a measured power level of the emitted radiation 5 and a target power level of the emitted radiation.

The control means 22 and 50 are then adapted for first 1) re-calibrating the change current I_delta_0, using the corresponding threshold current I_THR_0, to a re-calibrated change current I_delta_1 by application of the power difference delta_P. The power difference delta_P is obtained from the forward sensing means (FS) 40 and the related circuits. In the graph of Figure 3, the re-calibration corresponds to changing the slope of curve A resulting in curve B; curve B having a change current I_delta_1 slightly smaller than the change current I_delta_0 of curve A. Notice that the threshold current I_THR_0 is not modified by the re-calibration performed according to the present invention.

Furthermore the control means 22 and 50 are then adapted for secondly 2) applying the re-calibrated change current I_delta_1 together with the calibrated threshold current I_THR_0 for controlling the current source in a reading or a writing session. However, the re-calibration of the present invention can actually be undertaken during or in parallel to a reading or a writing session as the forward sensing monitoring of the power facilitates such a pre-calibration.

In Figure 3, the first predetermined power level is indicated as a read power level P_READ, but this needs not always be the case. Similarly, the second predetermined power level is indicated as a write power level P_WRITE, but this could also be another kind of power level e.g. an erasure power level.

Figure 4 is a graph schematically showing the timing of the present invention in an embodiment of the invention. During a transition from read R to write W, the optical drive can implement the present invention during a predetermined re-calibration period RCP wherein an closed-loop radiation power control loop is temporally opened. This is necessary to allow for the re-calibration to take place.

During a first sub-period RCP1 any transients from the power control loop are allowed to substantially die out so that these transients do not influence the re-calibration. The period RCP1 can last about 10 microseconds depending on the specific optical system in the optical drive.

During a second sub-period RCP2 the change current I_delta_0 is re-calibrated according to the teaching of the present invention. The sub-period RCP2 can last about 1 millisecond depending on the required precision of the re-calibration. The bandwidth of processor 50 can also influence the length of RCP2.

It should be mentioned with respect to Figure 4, that the re-calibration can be performed in parallel with the writing period W. Thus, while the optical drive has initiated a writing session W, the optical drive can simultaneously perform a re-calibration according to the present invention utilizing the power levels of the emitted radiation 5 to determine one or more power errors delta_P as input for the re-calibration needed.

In Figure 4, the re-calibration is shown as being performed at the start of a writing session W, but alternatively or additionally the re-calibration according to the present invention could be performed at regular intervals during a written session W. For example, the re-calibration could be performed halfway - or in other fractions - through a writing session. Likewise, the re-calibration could be performed regularly after a predetermined number of write pulses emitted from the radiation source 4 in order to compensate for any drift of the radiation source 4.

The temperature of the radiation source 4 is substantially constant during the second sub-period RCP2 as this - at least to some extent - justifies the requirement of the re-calibration, the requirement being that the corresponding threshold current I_THR_0 is kept constant during the fine-tuning of the change current from I_delta_0 to I_delta_1.

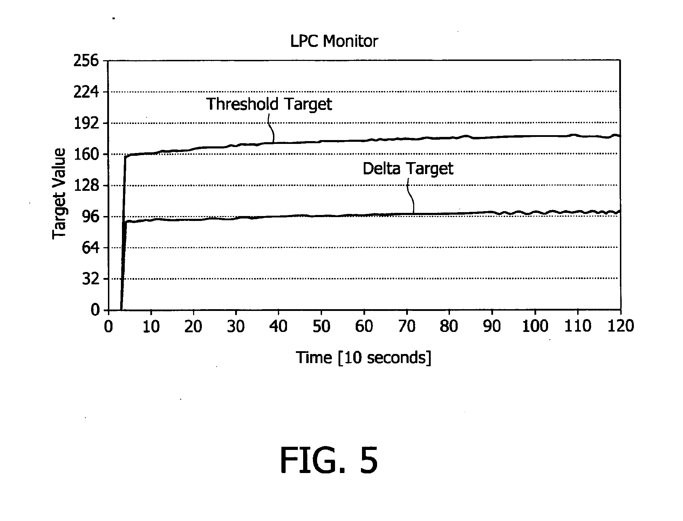

Figure 5 is an explanatory graph showing the temperature development in the threshold current and the change current for a laser. On the horizontal scale, time is indicated in tens of seconds. The temperature of the laser is increasing with time and therefore this scale can also be taken as a measure of the laser temperature. On the vertical scale is shown the threshold current and the change current in arbitrary units. The sudden rise in the beginning of the measuring period is a transient of the measuring period. It is observed that a moderate increase in the threshold current and the change current of the laser takes places over time i.e. as the laser temperature increases. However, the change of the threshold current and the change current are moderate on the time scale of seconds or lower. Hence, the assumption that the threshold current I_THR_0 is constant during the second sub-period RCP2 (and some time thereafter) is a reasonable approximation when considering Figure 5.

The electronic circuitry necessary for implementing the timing procedures shown in Figure 4 can be envisioned in many different ways by the person skilled in the art. Thus, in one embodiment two timers are provided, one timer for by-passing the closed loop power control provided by the forward sensing (FS) during the period RCP, and another timer delayed by the first sub-period RCP1 initiates the second sub-period RCP2 where the re-calibration according to the present invention takes place.

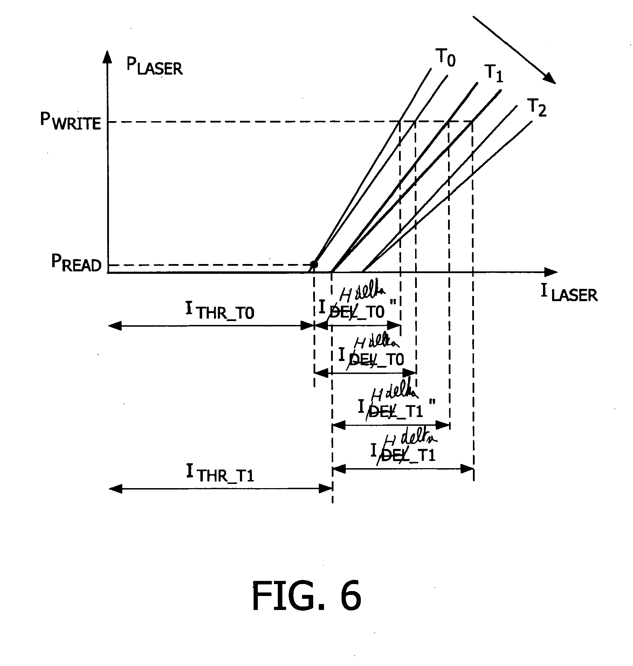

Figure 6 is a graph similar to the graph of Figure 3 at three different temperatures, respectively T0, T1, and T2. The temperature is increasing as indicated by the arrow above the temperatures; T0 < T1 < T2. For temperatures T0 and T1 the threshold currents, respectively I_THR_T0 and I_THR_1, are indicated below the graph. As a part of the re-calibration performed according to the present invention the change current is re-calibrated from I_delta_T0 to I_ delta_T0" and from I_delta_T1 to I_delta_T1", respectively. However, the threshold currents are not modified by the present invention. Nevertheless, the threshold current I_THR_T0 can be change to I_THR_T1 by other means. One example could be the updating process of the thresholds current disclosed in WO 2004/105004. Alternatively, the threshold currents can be scaled according to formula (1) and (2) above if the factor "a" is known or can be estimated for the radiation source 4 of the optical drive.

In the example of Figure 6, the threshold current is shown to be increasing with the temperature. Similarly, the slope i.e. the laser efficiency η is shown to be decreasing with the temperature (due to the increasing changing current I_delta). This is a general response of all types of lasers used in optical storage, but other ways of responding to increasing temperatures are also seen in this technical field.

In a situation where the threshold current is not updated, e.g. from I_THR_T0 to I_THR_1, as a result of a changing temperature, e.g. from T0 to T1, of the optical drive, in particular of the radiation source 4, the present invention can nevertheless provide some compensation of the power error in the radiation beam 5 with the fine-tuning of the change current I_delta. Accordingly, the teaching of the present invention can be applied both for a situation where the temperature (or indications therefore) of radiation source 4 is known, and for a situation where the temperature of the radiation source 4 is not precisely known.

If the power-current response of the radiation source 4 is showing a non-linear behavior due to e.g. extensive heating and/or malfunctions, the present invention can also to some extent provide compensation for such non-linear behavior, though the present invention is of course performing most advantageously when the radiation source 4 is responding in a substantially linear manner with respect to the power-current response.

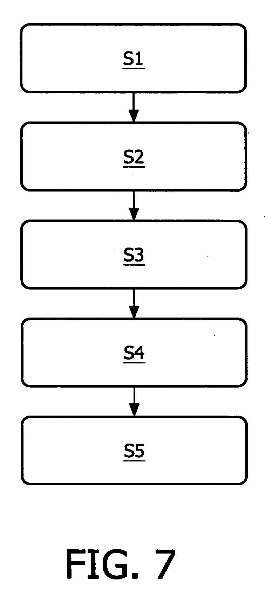

Figure 7 is a flow chart of a method according to the invention. The method comprises the steps of:

**S1** providing a current from a current source a to radiation source 4,

**S2** providing control means 50 and 22 adapted to control the current source, the control means having stored calibrated values for:

- a threshold current I_THR_0 at which the radiation source 4 radiates at a first predetermined power level P_1, and
- a change current I_delta_O for which the threshold current needs to be increased in order to enable the radiation source 4 to radiate at a second predetermined power level P_2,

**S3** obtaining a power difference delta_P between a measured power level of the emitted radiation and a target power level of the emitted radiation,

**S4** re-calibrating the change current I_delta_0 using the corresponding threshold-current I_THR_0 to a re-calibrated change current I_delta_1 by application of the power difference delta_P, and

**S5** applying the re-calibrated change current I_delta_1 together with the calibrated threshold current I_THR_0 for controlling the current source.

Although the present invention has been described in connection with the specified embodiments, it is not intended to be limited to the specific form set forth herein. Rather, the scope of the present invention is limited only by the accompanying claims. In the claims, the term "comprising" does not exclude the presence of other elements or steps. Additionally, although individual features may be included in different claims, these may possibly be advantageously combined, and the inclusion in different claims does not imply that a combination of features is not feasible and/or advantageous. In addition, singular references do not exclude a plurality. Thus, references to "a", "an", "first", "second" etc. do not preclude a plurality. Furthermore, reference signs in the claims shall not be construed as limiting the scope.

**Claims**

1. An optical drive for recording information on an associated optical carrier (1), the optical drive comprising:

   - a radiation source (4) arranged to be powered by a current provided by a current source,

- control means (50, 22) adapted to control the current source, the control means having a stored calibrated value for:

a threshold current (I_THR_0) at which the radiation source (4) radiates at a first predetermined power level (P_1),
- power controlling means (40, 41, 50) capable of obtaining a power difference (delta_P) between a measured power level of the emitted radiation and a target power level of the emitted radiation, **characterised in that** the control means furthermore has a stored calibrated value for a change current (I_delta_0) for which the threshold current needs to be increased in order to enable the radiation source (4) to radiate at a second predetermined power level (P_2),

and

wherein the control means (50, 22) is adapted for:

1) re-calibrating the change current (I_delta_0), using the corresponding threshold current (I_THR_0), to a re-calibrated change current (I_delta_1) by application of the power difference (delta_P), and
2) applying the re-calibrated change current (I_delta_1) together with the calibrated threshold current (I_THR_0) for controlling the current source.

2. An optical drive according to claim 1, wherein the control means (50, 22) is further adapted for 3) applying the re-calibrated change current (I_delta_1) and the calibrated threshold current (I_THR_0) to implement a write strategy comprising multiple power levels.

3. An optical drive according to claim 2, wherein the write strategy is also capable of erasing an optically readable effect on the associated carrier (1).

4. An optical drive according to claim 1, wherein the optical drive is adapted so that the step 1) of re-calibrating is performed in parallel with a writing process (W) being performed by the optical drive.

5. An optical drive according to claim 1 or claim 4, wherein the step 1) of re-calibrating is performed during a predetermined re-calibration period (RCP) wherein an closed-loop power control loop is temporally opened.

6. An optical drive according to claim 5, wherein the re-calibration period (RCP) comprises a first sub-period (RCP1), wherein any transients from the power control loop are allowed substantially die out, and a second sub-period (RCP2), wherein the change current (I_delta_0) is re-calibrated.

7. An optical drive according to claim 6, wherein the temperature of the radiation source (4) is substantially constant during the second sub-period (RCP2).

8. An optical drive according to claim 1, wherein the calibrated threshold current (I_THR_0) and/or the calibrated change current (I_delta_0) are stored in the control means (50, 22) during manufacturing of the optical drive.

9. An optical drive according to claim 1, wherein the calibrated threshold current (I_THR_0) and/or the calibrated change current (I_delta_0) are stored in the control means (50, 22) during a previous in-use calibration.

10. An optical drive according to claim 9, wherein the previous in-use calibration comprises the sub-step of determining the radiation power and the corresponding change current for at least two different threshold currents.

11. Control means (50, 22) adapted for controlling an optical drive capable of recording on an optical carrier (1), the control means being adapted to control a current source for powering a radiation source (4), the control means having a stored calibrated value for:

a threshold current (I_THR_0) at which the radiation source (4) radiates at a first predetermined power level (P_1), **characterised in that** the control means furthermore has a stored calibrated value for:

a change current (I_delta_O) for which the threshold current needs to be increased in order to enable the radiation source to radiate at a second predetermined power level (P_2), and

wherein the control means is adapted for:

1) re-calibrating the change current (I_delta_0), using the corresponding threshold current (I_THR_0), to a re-calibrated change current (I_delta_1) by application of a power difference (delta_P) between a measured power level of the emitted radiation (5) and a target power level of the emitted radiation (5), and
2) applying the re-calibrated change current (I_delta_1) together with the calibrated threshold current (I_THR_0) for controlling the current source.

12. A method for operating an optical drive for recording information on an optical carrier (1), the method comprising the steps of:

- providing a current from a current source a to radiation source (4),
- providing control means (50, 22) adapted to control the current source, the control means having stored calibrated values for:

- a threshold current (I_THR_0) at which the radiation source (4) radiates at a first predetermined power level (P_1), and
- a change current (I_delta_0) for which the threshold current needs to be increased in order to enable the radiation source (4) to radiate at a second predetermined power level (P_2),

- obtaining a power difference (delta_P) between a measured power level of the emitted radiation and a target power level of the emitted radiation,
- re-calibrating the change current (I_delta_0), using the corresponding threshold current (I_THR_0), to a re-calibrated change current (I_delta_1) by application of the power difference (delta_P), and
- applying the re-calibrated change current (I_delta_1) together with the calibrated threshold current (I_THR_0) for controlling the current source.

13. A computer program product being adapted to enable a computer system comprising at least one computer having data storage means associated therewith to control an optical drive according to claim 12.

**Patentansprüche**

1. Optisches Laufwerk zur Aufzeichnung von Informationen auf einem zugeordneten, optischen Träger (1), wobei das optische Laufwerk umfasst:

- eine Strahlungsquelle (4), die so vorgesehen ist, dass sie von einem, von einer Stromquelle abgegebenen Strom gespeist wird,
- Steuermittel (50, 22), die so eingerichtet sind, dass sie die Stromquelle steuern, wobei die Steuermittel einen gespeicherten, kalibrierten Wert aufweisen für:

- einen Schwellstrom (I_THR_0), bei dem die Strahlungsquelle (4) bei einem ersten vorgegebenen Leistungspegel (P_1) strahlt,
sowie

- Leistungssteuermittel (40, 41, 50), die imstande sind, eine Leistungsdifferenz (delta_P) zwischen einem gemessenen Leistungspegel der emittierten Strahlung und einem Zielleistungspegel der emittierten Strahlung vorzusehen, **dadurch gekennzeichnet, dass** die Steuermittel weiterhin einen gespeicherten, kalibrierten Wert aufweisen für:

- einen Wechselstrom (I_delta_0), für den der Schwellstrom zu erhöhen ist, damit die Strahlungsquelle (4) bei einem zweiten vorgegebenen Leistungspegel (P_2) strahlen kann,

und wobei die Steuermittel (50, 22) eingerichtet sind zum:

1) Rekalibrieren des Wechselstroms (I_delta_0) unter Verwendung des entsprechenden Schwellstroms (I_THR_0) in einen rekalibrierten Wechselstrom (I_delta_1) durch Einsetzen der Leistungsdifferenz (delta_P), sowie

2) Anlegen des rekalibrierten Wechselstroms (I_delta_1) zusammen mit dem kalibrierten Schwellstrom (I_THR_0) zur Steuerung der Stromquelle.

**2.** Optisches Laufwerk nach Anspruch 1, wobei die Steuermittel (50, 22) weiterhin zum 3) Anlegen des rekalibrierten Wechselstroms (I_delta_1) sowie des kalibrierten Schwellstroms (I_THR_0) eingerichtet sind, um eine Schreibstrategie mit mehreren Leistungspegeln zu implementieren.

**3.** Optisches Laufwerk nach Anspruch 2, wobei die Schreibstrategie ebenfalls imstande ist, einen optisch lesbaren Effekt auf dem zugeordneten Träger (1) zu löschen.

**4.** Optisches Laufwerk nach Anspruch 1, wobei das optische Laufwerk so eingerichtet ist, dass der Schritt 1) des Rekalibrierens parallel zu einem durch das optische Laufwerk durchgeführten Schreibprozess ausgeführt wird.

**5.** Optisches Laufwerk nach Anspruch 1 oder Anspruch 4, wobei der Schritt 1) des Rekalibrierens während einer vorgegebenen Rekalibrierungsperiode (RCP) ausgeführt wird, in der ein geschlossener Leistungsregelkreis zeitweilig geöffnet wird.

**6.** Optisches Laufwerk nach Anspruch 5, wobei die Rekalibrierungsperiode (RCP) eine erste Teilperiode (RCP1), in welcher Übergangszustände von dem Leistungsregelkreis im Wesentlichen allmählich aufhören dürfen, und eine zweite Teilperiode (RCP2), in welcher der Wechselstrom (I_delta_0) rekalibriert wird, umfasst.

**7.** Optisches Laufwerk nach Anspruch 6, wobei die Temperatur der Strahlungsquelle (4) während der zweiten Teilperiode (RCP2) im Wesentlichen konstant ist.

**8.** Optisches Laufwerk nach Anspruch 1, wobei der kalibrierte Schwellstrom (I_THR_0) und/oder der kalibrierte Wechselstrom (I_delta_0) während der Herstellung des optischen Laufwerks in den Steuermitteln gespeichert werden.

**9.** Optisches Laufwerk nach Anspruch 1, wobei der kalibrierte Schwellstrom (I_THR_0) und/oder der kalibrierte Wechselstrom (I_delta_0) während einer vorhergehenden, in Anspruch genommenen Kalibrierung in den Steuermitteln gespeichert werden.

**10.** Optisches Laufwerk nach Anspruch 9, wobei die vorhergehende, in Anspruch genommene Kalibrierung den Teilschritt des Ermittelns der Strahlungsleistung und des entsprechenden Wechselstroms für mindestens zwei verschiedene Schwellströme umfasst.

**11.** Steuermittel (50, 22), die so eingerichtet sind, dass sie ein optisches Laufwerk steuern, welches imstande ist, eine Aufzeichnung auf einem optischen Träger (1) vorzunehmen, wobei die Steuermittel so eingerichtet sind, dass sie eine Stromquelle zur Speisung einer Strahlungsquelle (4) steuern, wobei die Steuermittel einen gespeicherten, kalibrierten Wert aufweisen für:

einen Schwellstrom (I_THR_0), bei dem die Strahlungsquelle (4) bei einem ersten vorgegebenen Leistungspegel (P_1) strahlt, **dadurch gekennzeichnet, dass** die Steuermittel weiterhin einen gespeicherten, kalibrierten Wert aufweisen für:

einen Wechselstrom (I_delta_0), für den der Schwellstrom zu erhöhen ist, damit die Strahlungsquelle bei einem zweiten vorgegebenen Leistungspegel (P_2) strahlen kann, und

wobei die Steuermittel eingerichtet sind zum:

1) Rekalibrieren des Wechselstroms (I_delta_0) unter Verwendung des entsprechenden Schwellstroms (I_THR_0) in einen rekalibrierten Wechselstrom (I_delta_1) durch Einsetzen einer Leistungsdifferenz (delta_P) zwischen einem gemessenen Leistungspegel der emittierten Strahlung (5) und einem Zielleistungspegel der emittierten Strahlung (5), und
2) Anlegen des rekalibrierten Wechselstroms (I_delta_1) zusammen mit dem kalibrierten Schwellstrom (I_THR_0) zur Steuerung der Stromquelle.

**12.** Verfahren zum Betreiben eines optischen Laufwerks zur Aufzeichnung von Informationen auf einem optischen Träger (1), wobei das Verfahren die folgenden Schritte umfasst:

- Zuführen eines Stroms aus einer Stromquelle zu einer Strahlungsquelle (4),
- Vorsehen von Steuermitteln (50, 22), die so eingerichtet sind, dass sie die Stromquelle steuern, wobei die Steuermittel gespeicherte, kalibrierte Werte aufweisen für:

- einen Schwellstrom (I_THR_0), bei dem die Strahlungsquelle (4) bei einem ersten vorgegebenen Leistungspegel (P_1) strahlt, sowie
- einen Wechselstrom (I_delta_0), für den der Schwellstrom zu erhöhen ist, damit die Strahlungsquelle (4) bei einem zweiten vorgegebenen Leistungspegel (P_2) strahlen kann,

- Vorsehen einer Leistungsdifferenz (delta_P) zwischen einem gemessenen Leistungspegel der emittierten Strahlung und einem Zielleistungspegel der emittierten Strahlung,
- Rekalibrieren des Wechselstroms (I_delta_0) unter Verwendung des entsprechenden Schwellstroms (I_THR_0) in einen rekalibrierten Wechselstrom (I_delta_1) durch Einsetzen der Leistungsdifferenz (delta_P), sowie
- Anlegen des rekalibrierten Wechselstroms (I_delta_1) zusammen mit dem kalibrierten Schwellstrom (I_THR_0) zur Steuerung der Stromquelle.

13. Computerprogrammprodukt, welches so eingerichtet ist, dass es einem Computersystem, das mindestens einen Computer mit diesem zugeordneten Datenspeichermitteln umfasst, die Möglichkeit gibt, ein optisches Laufwerk nach Anspruch 12 zu steuern.

**Revendications**

1. Lecteur optique destiné à enregistrer des informations sur un support optique associé (1), le lecteur optique comprenant :

- une source de rayonnement (4) agencée pour être alimentée par un courant fourni par une source de courant,
- des moyens de commande (50, 22) adaptés pour commander la source de courant, les moyens de commande possédant des valeurs calibrées stockées pour :

un courant de seuil (I_THR_0) auquel la source de rayonnement (4) rayonne à un premier niveau de puissance prédéterminé (P_1), et

- des moyens de commande de puissance (40, 41, 50) capables d'obtenir une différence de puissance (delta_P) entre un niveau de puissance mesuré du rayonnement émis et un niveau de puissance cible du rayonnement émis, **caractérisé en ce que** les moyens de commande possèdent en outre une valeur calibrée stockée pour :

un courant de changement (I_delta_0) pour lequel le courant de seuil doit être augmenté afin de permettre à la source de rayonnement (4) de rayonner à un second niveau de puissance prédéterminé (P_2),

dans lequel les moyens de commande (50, 22) sont adaptés pour :

1) recalibrer le courant de changement (I_delta_0), à l'aide du courant de seuil correspondant (I_THR_0), à un courant de changement recalibré (I_delta_1) par application de la différence de puissance (delta_P), et
2) appliquer le courant de changement recalibré (I_delta_1) conjointement au courant de seuil calibré (I_THR_0) pour commander la source de courant.

2. Lecteur optique selon la revendication 1, dans lequel les moyens de commande (50, 22) sont en outre adaptés pour 3) appliquer le courant de changement recalibré (I_delta_1) et le courant de seuil calibré (I_THR_0) pour implémenter une stratégie d'écriture comprenant de multiples niveaux de puissance.

3. Lecteur optique selon la revendication 2, dans lequel la stratégie d'écriture est également capable d'effacer un effet lisible optiquement sur le support associé (1).

4. Lecteur optique selon la revendication 1, dans lequel le lecteur optique est adapté de sorte que l'étape 1) consistant à recalibrer est exécutée en parallèle à un processus d'écriture (W) exécuté par le lecteur optique.

5. Lecteur optique selon la revendication 1 ou la revendication 4, dans lequel l'étape 1) consistant à recalibrer est exécutée au cours d'une période de recalibration prédéterminée (RCP) dans lequel une boucle de commande de puissance à boucle fermée est temporairement ouverte.

6.  Lecteur optique selon la revendication 5, dans lequel la période de recalibration (RCP) comprend une première sous-période (RCP1), durant laquelle de quelconques transitoires à partir de la boucle de commande de puissance sont autorisés à sensiblement disparaître, et une seconde sous-période (RCP2), durant laquelle le courant de changement (I_delta_0) est recalibré.

7.  Lecteur optique selon la revendication 6, dans lequel la température de la source de rayonnement (4) est sensiblement constante au cours de la seconde sous-période (RCP2).

8.  Lecteur optique selon la revendication 1, dans lequel le courant de seuil calibré (I_THR_0) et/ou le courant de changement calibré (I_delta_0) sont stockés dans les moyens de commande (50, 22) au cours de la fabrication du lecteur optique.

9.  Lecteur optique selon la revendication 1, dans lequel le courant de seuil calibré (I_THR 0) et/ou le courant de changement calibré (I_delta_0) sont stockés dans les moyens de commande (50, 22) au cours d'une calibration en usage antérieure.

10. Lecteur optique selon la revendication 9, dans lequel la calibration en usage antérieure comprend la sous-étape consistant à déterminer la puissance de rayonnement et le courant de changement correspondant pour au moins deux courants de seuil différents.

11. Moyens de commande (50, 22) adaptés pour commander un lecteur optique capable de réaliser un enregistrement sur un support optique (1), les moyens de commande étant adaptés pour commander une source de courant pour alimenter une source de rayonnement (4), les moyens de commande possédant une valeur calibrée stockée pour :

    un courant de seuil (I_THR_0) auquel la source de rayonnement (4) rayonne à un premier niveau de puissance prédéterminé (P_1), **caractérisés en ce que** les moyens de commande possèdent en outre une valeur calibrée stockée pour :

    un courant de changement (I_delta_0) pour lequel le courant de seuil doit être augmenté afin de permettre à la source de rayonnement de rayonner à un second niveau de puissance prédéterminé (P_2), et

    dans lesquels les moyens de commande sont adaptés pour :

    1) recalibrer le courant de changement (I_delta_0), à l'aide du courant de seuil correspondant (I_THR_0), à un courant de changement recalibré (I_delta_1) par application d'une différence de puissance (delta_P) entre un niveau de puissance mesuré du rayonnement émis (5) et un niveau de puissance cible du rayonnement émis (5), et
    2) appliquer le courant de changement recalibré (I_delta_1) conjointement au courant de seuil calibré (I_THR_0) pour commander la source de courant.

12. Procédé pour faire fonctionner un lecteur optique destiné à enregistrer des informations sur un support optique (1), le procédé comprenant les étapes consistant à :

    - fournir un courant à partir d'une source de courant à une source de rayonnement (4),
    - fournir des moyens de commande (50, 22) adaptés pour commander la source de courant, les moyens de commande possédant des valeurs calibrées stockées pour :

       - un courant de seuil (I_THR_0) auquel la source de rayonnement (4) rayonne à un premier niveau de puissance prédéterminé (P_1), et
       - un courant de changement (I_delta_0) pour lequel le courant de seuil doit être augmenté afin de permettre à la source de rayonnement (4) de rayonner à un second niveau de puissance prédéterminé (P_2),

    - obtenir une différence de puissance (delta_P) entre un niveau de puissance mesuré du rayonnement émis et un niveau de puissance cible du rayonnement émis,
    - recalibrer le courant de changement (I_delta_0), à l'aide du courant de seuil correspondant (I_THR_0), à un courant de changement recalibré (I_delta_1) par application de la différence de puissance (delta_P), et

- appliquer le courant de changement recalibré (I_delta_1) conjointement au courant de seuil calibré (I_THR_0) pour commander la source de courant.

13. Produit programme informatique adapté pour permettre à un système informatique comprenant au moins un ordinateur possédant des moyens de stockage de données associés à celui-ci de commander un lecteur optique selon la revendication 12.

# FIG. 1

FIG. 2

FIG. 3

FIG. 4

FIG. 5

**FIG. 6**

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6577655 B
- US 200400552185 A
- WO 2004105004 A
- US 6408013 B1